(19) Europäisches Patentamt / European Patent Office / Office européen des brevets

(11) **EP 3 217 445 B1**

(12) **EUROPEAN PATENT SPECIFICATION**

(45) Date of publication and mention
of the grant of the patent:
**04.09.2019 Bulletin 2019/36**

(51) Int Cl.:
*H01L 27/22* (2006.01)    *H01L 43/06* (2006.01)
*H01L 43/10* (2006.01)    *H01L 43/12* (2006.01)
*H01L 43/14* (2006.01)    *H01L 43/08* (2006.01)

(21) Application number: **16748933.5**

(22) Date of filing: **12.02.2016**

(86) International application number:
**PCT/JP2016/000726**

(87) International publication number:
**WO 2016/129288 (18.08.2016 Gazette 2016/33)**

(54) **SENSOR DEVICE**

SENSORVORRICHTUNG

DISPOSITIF DÉTECTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.02.2015 JP 2015025277**

(43) Date of publication of application:
**13.09.2017 Bulletin 2017/37**

(73) Proprietor: **Asahi Kasei Microdevices Corporation
Tokyo 100-0006 (JP)**

(72) Inventor: **NAKAMURA, Masahiro
Tokyo 101-8101 (JP)**

(74) Representative: **Hoffmann Eitle
Patent- und Rechtsanwälte PartmbB
Arabellastraße 30
81925 München (DE)**

(56) References cited:
**WO-A1-00/28342          WO-A1-03/061025
JP-A- H02 306 183        JP-A- H03 144 387
JP-A- H03 261 869        JP-A- 2002 299 599
JP-A- 2002 299 725       JP-A- 2002 299 728
JP-A- 2006 047 080       KR-A- 20100 124 493
US-A1- 2006 202 291**

**Description**

Technical Field

The present invention relates to a sensor device and more specifically relates to a sensor device in which sensor elements detecting changes in a predetermined physical quantity are integrated during a wiring process of a semiconductor.

Background Art

Heretofore, a magnetic sensor device is known in which a plurality of hall elements are disposed to obtain a position signal in three-dimensional space. As this kind of magnetic sensor device, a magnetic detection type pointing device is also known which is used as input means of a personal computer and the like and which performs coordinate detection by detecting changes in a magnetic field due to the movement of a magnet.

For example, PTL 1 discloses a magnetic sensor of a hybrid configuration in which hall elements 11 and a device 1 are packaged.

Fig. 1 is a block diagram for explaining a pointing device described in PTL 1. As illustrated in Fig. 1, PTL 1 describes a pointing device having a detecting unit 1 having four hall elements 11, two pairs of which are symmetrically disposed along the X-axis and the Y-axis, differential amplifiers 2 which each differentially amplify the output of each of the hall elements 11 in the X-axis direction and the Y-axis direction due to the movement of a magnet provided above the hall element 11, an A/D converter 3 converting the outputs of the differential amplifier 2 to digital values, a detection controlling unit 4 converting an output (voltage) of the A/D converter 3 to an X-Y coordinate value, a coordinate converting unit 5 converting the output of the detection controlling unit 4 to a polar coordinate, and a coordinate switching unit 6 which receives both the X-Y coordinate value from the detection controlling unit 4 and the polar coordinate value from the coordinate converting unit 5, and then selectively outputs either one of the values. In the figure, the reference numeral 7 denotes an output method storage unit, the reference numeral 8 denotes an output controlling unit, the reference numeral 51 denotes a distance calculating unit, the reference numeral 52 denotes an angle calculating unit, and the reference numeral 53 denotes a distance output limiting unit.

Moreover, for example, PTL 2 discloses a magnetic sensor of a monolithic configuration in which hall elements are formed on a silicon substrate.

Fig. 2 is a block diagram for explaining a magnetic sensor for pointing device described in PTL 2. A silicon integrated circuit 22 contains a differential amplifier, a detection controlling unit, and an output controlling unit, in which two pairs of hall elements 21 are symmetrically disposed along the X-axis and the Y-axis and the hall elements 21 and the integrated circuit 22 are formed on the same silicon chip. The integrated circuit 22 is die-bonded to a lead frame 23 and the integrated circuit 22 is electrically joined to the lead frame 23 with wires 25. The entire sensor is integrally molded with a mold resin 24. This results in the fact that a magnetic sensor having small characteristic variations is used and simultaneously that the position accuracy of the arrangement place of the magnetic sensor can be improved and the influence of noise is hard to receive when a signal is transmitted to the detection controlling unit from the magnetic sensor.

Moreover, for example, PTL 3 describes a semiconductor composite device having a semiconductor substrate having an integrated circuit, a planarized region formed on the surface of the semiconductor substrate, and a semiconductor thin film having semiconductor elements and stuck onto the planarized region. As the semiconductor elements, a light emitting element, a light receiving element, a hall element, and a piezoelectric element are disclosed.

Citation List

Patent Literature

PTL 1: JP 10-20999 A
PTL 2: JP 2004-69695 A
PTL 3: JP 2004-207323 A

Further, KR 10-2010-0124493 A discloses a sensor device comprising a substrate, a first wiring layer provided on the substrate, a first insulating layer provided on the first wiring layer, a compound semiconductor magnetic sensor element provided on the first insulating layer, a second wiring layer provided on the compound semiconductor sensor element and the first insulating layer; and a second insulating layer provided on the second wiring layer. Still further devices are described by US 2006 / 0202291 A1, JP 2002-299599 A, JP 2006-47080 A and WO 00 / 28342 A1.

Summary of Invention

Technical Problem

However, the hybrid configuration of PTL 1 described above is a configuration in which the hall elements and the device are connected with wires. Therefore, a compound semiconductor hall element which is a hall element with high sensitivity can be used but the thickness and the size as the entire magnetic sensor become large. Moreover, there is a problem in that the magnetic sensor is directly affected by the influence of a disturbance noise.
According to the monolithic configuration of PTL 2 described above, the hall element is a silicon hall element formed on a silicon substrate, and therefore the size is small but there is a problem in that an improvement of magnetic sensitivity is limited. Furthermore, according to the configuration of PTL 3 described above, there is a problem in that the device is affected by the influence of a disturbance noise.
The present invention has been made in view of such problems. It is an object of the present invention to provide a sensor device which is small and strong against a disturbance noise in a sensor device having a compound semiconductor sensor element.

Solution to Problem

According to the present invention, the sensor device comprises a semiconductor substrate; a first compound semiconductor magnetic sensor provided in an insulating layer between a first metal wiring layer and a second metal wiring layer provided on the semiconductor substrate; and a second compound semiconductor magnetic sensor provided in an insulating layer between the second metal wiring and a third metal wiring layer on the second metal wiring layer, wherein the second compound semiconductor magnetic sensor is formed above the first compound semiconductor magnetic sensor as viewed in a cross section.

Advantageous Effects of Invention

According to the present invention, since the compound semiconductor magnetic sensors are disposed in the vertical direction as viewed in a cross section in one chip instead of different IC chips, there is no error in assembly and an accurate functional security can be achieved.

Brief Description of Drawings

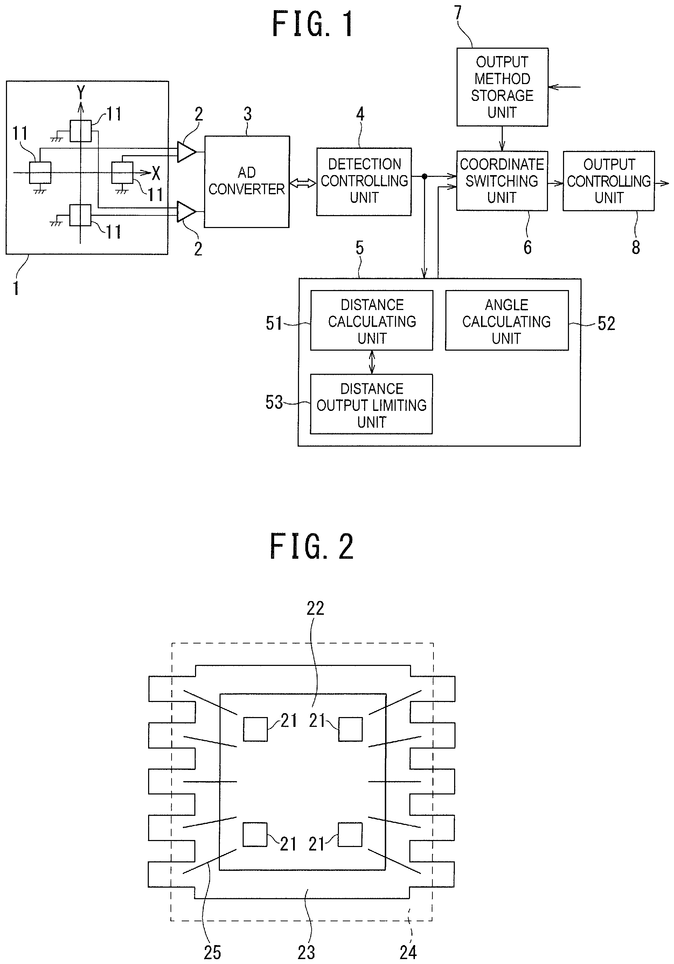

Fig. 1 is a block diagram for explaining a pointing device described in PTL 1;
Fig. 2 is a block diagram for explaining a magnetic sensor for pointing device described in PTL 2;
Figs. 3A and 3B are block diagrams for explaining Example 1 of a sensor device for illustrating a sensor device according to the present invention;
Figs. 4A to 4C are process flow diagrams (No. 1) for explaining a manufacturing method 1 for the sensor device according to Example 1;
Figs. 5D to 5F are process flow diagrams (No. 2) for explaining the manufacturing method 1 for the sensor device according to Example 1;
Figs. 6G to 6I are process flow diagrams (No. 3) for explaining the manufacturing method 1 for the sensor device according to Example 1;
Fig. 7 is a flow diagram for explaining the formation of a semiconductor thin film on a substrate in a manufacturing method 2 of Example 1;
Figs. 8A to 8C are process flow diagrams (No. 1) for explaining a manufacturing method 2 for the sensor device according to Example 1;
Figs. 9D to 9F are process flow diagrams (No. 2) for explaining the manufacturing method 2 for the sensor device according to Example 1;
Figs. 10G to 10I are process flow diagrams (No. 3) for explaining the manufacturing method 2 for the sensor device according to Example 1;
Figs. 11A and 11B are block diagrams for explaining Example 2 of a sensor device for illustrating a sensor device according to the present invention;
Fig. 12 is a circuit diagram illustrating an example of a compound semiconductor sensor element and a semiconductor integrated circuit in an application example of the sensor devices of Examples 1 and 2;
Fig. 13 is a circuit diagram illustrating an example in which the temperature characteristics of the sensor devices can be made constant in an application example of the sensor devices of Examples 1 and 2; and
Fig. 14 is a circuit diagram illustrating another example in which the temperature characteristics of the sensor devices can be made constant in an application example of the sensor devices of Examples 1 and 2.

Description of Embodiments

In the following detailed description, a large number of specific concrete configurations are described in order to give perfect understanding of examples for illustrating a sensor device according of the present invention.

A sensor device of this example has a semiconductor substrate, a first metal wiring layer formed on the semiconductor substrate, a first insulating layer formed on the first metal wiring layer, a compound semiconductor sensor element formed on the first insulating layer, a second metal wiring layer formed on the compound semiconductor sensor element and the first insulating layer, and a second insulating layer formed on the second metal wiring layer.

As the semiconductor substrate, a silicon substrate has a semiconductor device region formed thereon, for example. Devices, such as an NMOS transistor, a PMOS transistor, a bipolar transistor, a capacitor, and a resistance, are formed in the semiconductor device region.

Examples of the compound semiconductor sensor element include, for example, magnetic sensors, such as a hall element and a magnetoresistive element, a current sensor, a distortion sensor, a pressure sensor, a temperature sensor, an acceleration meter, and the like. The sensor element may have a thin film shape. Or, a compound semiconductor hall element may be acceptable. Specifically, a GaAs sensor element, an InAs sensor element, or an InSb sensor element, a GaAs sensor element, an InAs sensor element, or an InSb sensor element containing impurities, or the like is mentioned.

The first metal wiring layer electrically connects input/output portions of the devices or the sensor elements in the semiconductor device region, for example. The first metal wiring layer may be formed on the semiconductor substrate through an insulating layer. The first metal wiring layer may have a configuration of having a shield layer formed below the sensor element with the same material as that of the first metal wiring layer. The metal wiring is Al wiring, for example, and is formed by photolithography.

The first insulating layer is an insulating film of $SiO_2$, TEOS, SiN, or the like, for example. It is preferable that the first insulating layer has a planarized surface and the sensor elements are formed on the planarized surface. Two or more of the first metal wiring layers and the first insulating layers may be formed.

The second metal wiring layer is formed on the sensor element and the first insulating layer and the second insulating layer is formed on the second metal wiring layer. The sensor element may have a configuration of being electrically connected to the first metal wiring layer or the second metal wiring layer or electrically connected to both the first metal wiring layer and the second metal wiring layer. The second insulating layer is an insulating film of $SiO_2$, TEOS, SiN, or the like, for example.

A configuration may be acceptable in which an input/output PAD is formed as an external connection contact on the second insulating layer. Also when a metal wiring layer and an insulating layer are further formed on the second insulating layer, an external connection contact may be formed thereon. Furthermore, a configuration may be acceptable in which a solder bump of an external connection terminal to be connected to a PAD is formed, e.g., WLCSP and the like.

A configuration may be acceptable in which a third insulating layer is provided between the first metal wiring layer and the second metal wiring layer and the sensor element is formed in the third insulating layer.

According to this example, the sensor element is formed between the metal wiring layers of an upper wiring layer and a lower wiring layer in the sensor device, and therefore the sensor device can be miniaturized and is strong against a disturbance noise. In addition thereto, the degree of freedom of selection of sensors is also high. For example, a sensor device can be provided which can employ, as a sensor, a compound semiconductor hall element which has not been able to be employed in the monolithic configuration and which has high sensitivity and is small.

Hereinafter, each example for illustrating a sensor device according to the present invention is described with reference to the drawings.

<Example 1>

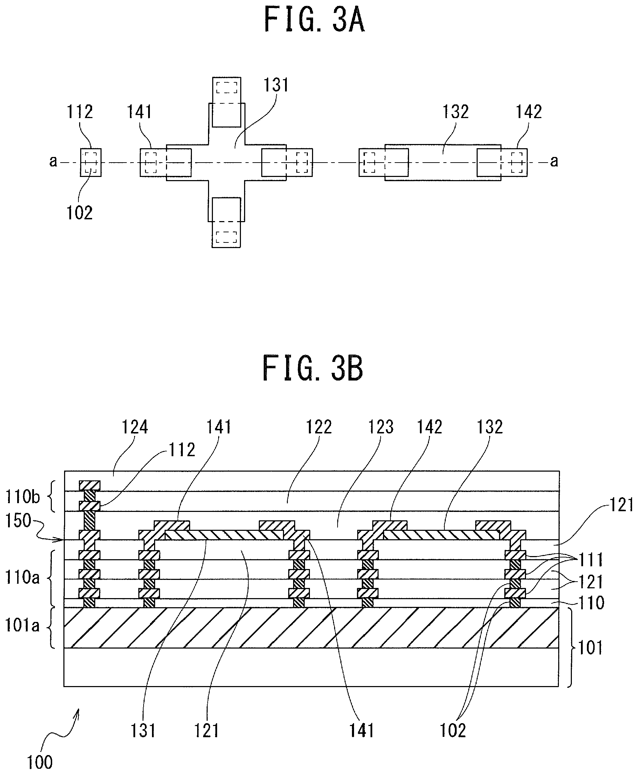

Figs. 3A and 3B are block diagrams for explaining Example 1 of the sensor device according to the present invention. Fig. 3A illustrates a top view and Fig. 3B illustrates a cross sectional view along the a-a line of Fig. 3A.

A sensor device 100 of Example 1 has a semiconductor substrate 101, a first metal wiring layer 111 formed on the semiconductor substrate 101, a first insulating layer 121 provided on the first metal wiring layer 111, a compound semiconductor sensor element 131 provided on the first insulating layer 121, a second metal wiring layer 112 provided on the compound semiconductor sensor element 131 and the first insulating layer 121, and a second insulating layer 122 provided on the second metal wiring layer 112.

Moreover, a third insulating layer 123 is provided between the first metal wiring layer 111 and the second metal wiring layer 112 and the compound semiconductor sensor element 131 is formed in the third insulating layer 123.

The compound semiconductor sensor element 131 is electrically connected to the first metal wiring layer 111 or the second metal wiring layer 112. Moreover, a lower wiring layer 110a having the first insulating layer 121 and the first metal wiring layer 111 is formed on the semiconductor substrate 101 and an upper wiring layer 110b having the second insulating layer 122 and the second metal wiring layer 112 is formed on the third insulating layer 123.

The compound semiconductor sensor element 131 preferably has a thin film shape. Moreover, a correction resistance element 132 provided on the same plane as a plane on which the compound semiconductor sensor element 131 is provided is further provided.

Moreover, a wiring 141 for sensor element is provided so that the terminal of the compound semiconductor sensor element 131 is connected to the second metal wiring layer 112 of the upper wiring layer 110b. One end of the correction resistance element 132 is connected to the upper wiring layer 110b and the other end thereof is connected to the lower wiring layer 110a.

The compound semiconductor sensor element 131 is preferably a hall element or a magnetoresistive element. The compound semiconductor sensor element 131 is formed on a planarized surface 150 of the first insulating layer 121. An external connection contact (not illustrated) can also be provided on the second insulating layer 122.

More specifically, the sensor device of Example 1 has the semiconductor substrate 101, the lower wiring layer 110a, the compound semiconductor sensor element 131, the wiring 141 for sensor element, the third insulating layer 123, and the upper wiring layer 110b as is clear from Figs. 3A and 3B.

The semiconductor substrate 101 is a silicon substrate, for example, and a semiconductor device region 101a in which a semiconductor integrated circuit is formed is formed therein. In the case of a CMOS process, devices, such as an NMOS transistor, a PMOS transistor, a capacitor, and a polysilicon resistance, are formed as an example in the semiconductor device region 101a. In the case of a bipolar process, an NPN transistor, a PNP transistor, or the like is formed according thereto in the semiconductor device region 101a.

The lower wiring layer 110a is formed on the semiconductor substrate 101. The lower wiring layer 110a has the first insulating layer 121 and the first metal wiring layer 111. An interlayer insulating layer 110 is formed on the semiconductor substrate 101, the first metal wiring layer 111 is formed on the interlayer insulating layer 110, and the first insulating layer 121 is formed thereon.

The metal wiring layer 111 is connected to the semiconductor integrated circuit through VIAs (connection region which electrically connects lower wiring and upper wiring in multilayer wiring) 102. Two or more of the first insulating layers 121 and the first metal wiring layers 111 are formed. Fig. 3B illustrates an example in which three layers of the VIAs 102 and the first metal wiring layers 111 are stacked up to a portion immediately below the wiring of the compound semiconductor sensor element 131.

The hall element which is the compound semiconductor sensor element 131 is formed on the first insulating layer 121 on the lower wiring layer 110a. Four terminals of the hall element are connected to the first metal wiring layer 111 of the lower wiring layer 110a with the wiring 141 for sensor element and to the semiconductor integrated circuit through the VIAs 102. The wiring 141 for sensor element is formed from the terminal of the hall element to the first metal wiring layer 111 through the first insulating layer 121.

The third insulating layer 123 is formed on the compound semiconductor sensor element 131 and the first insulating layer 121. On the third insulating layer 123, the upper wiring layer 110b is formed. The upper wiring layer 110b has the second insulating layer 122 and the second metal wiring layer 112. The second metal wiring layer 112 is formed on the third insulating layer 123, and the second insulating layer 122 is formed thereon.

The second metal wiring layer 112 is connected to the semiconductor integrated circuit through the VIAs 102. Two or more of the second insulating layers 122 and the second metal wiring layers 112 are formed. Fig. 3B illustrates an example in which two layers of the VIAs 102 and the second metal wiring layers 112 are repeated for wiring. Two or more wirings may be repeated and a top layer protective film 124 may be formed.

The correction resistance element 132 for correcting the characteristics of the compound semiconductor sensor element 131 is formed on the same plane as the plane on which the compound semiconductor sensor element 131 is formed on the first insulating layer 121. To both ends of the correction resistance element 132, wirings 142 for correction resistance elements are connected. The correction resistance element 132 is connected to the semiconductor integrated circuit through the lower wiring layer 110a as with the compound semiconductor sensor element 131.

Although not illustrated, external connection contacts (PAD and the like) may be formed on the upper wiring layer 110b.

The VIA 102 contains tungsten, for example. The first and second metal wiring layers 111 and 112 have a layer structure of tungsten/aluminum/tungsten in which aluminum is used as the main wiring material and tungsten is used as a barrier metal, for example.

The interlayer insulating layer 110 and the top layer protective film 124 are insulating films of $SiO_2$, TEOS, SiN, and the like, for example.

According to Example 1, the present invention is a sensor device in which the sensor element is formed between the metal wiring layers of the upper wiring layer and the lower wiring layer, and therefore the sensor device can be miniaturized and is strong against a disturbance noise. In addition, the degree of freedom of selection of sensors is also high.

For example, when position detection is performed with a magnetic signal to be input into the sensor having a magnitude of a geomagnetism level of 30 $\mu$T while the magnitude of a magnetic signal of a magnet is, for example, tens of mT, the magnetic sensitivity of a magnetic sensor is too small in a silicon hall element for use in monolithic articles, so that, in the case where the number of elements is four as described in PTL 2 described above, for example, the case where S/N of a magnetic signal of a required level cannot be taken occurs.

As a method for improving the S/N, it is considered to further increase the number of sensors to be disposed in the integrated circuit. For example, when a sensor placement area of about 100 um$^2$ per sensor is required, for example, it is considered that the number of the sensors to be disposed in an LSI chip is limited, so that desired S/N is not obtained.

As another method for improving the S/N, a method for increasing a current to be sent through the sensor until desired S/N is achieved is considered. However, the power supply voltage for use in portable devices in recent years is mainly a 1.8 V system with the subdivision of a semiconductor process, and, further, it is predicted that a 1.5 V system will be mainly used. Therefore, even when an attempt of increasing a current to be sent through the sensor is made in order to achieve required S/N, a current capable of achieving desired S/N cannot be sent through the sensor element due to the limitation of the drive power supply voltage.

On the other hand, in the case of a former hybrid structure, a hall element which achieves magnetic sensitivity higher than that of a silicon monolithic hall element can be selected, and thus desired S/N can be achieved. For example, when a sensor having 1800 $\mu$V/(mT$\times$V) which is given as an example of the magnetic sensitivity of an InSb thin film hall element compared to 60 $\mu$V/(mT$\times$V) which is given as an example of the magnetic sensitivity of a silicon hall element can be used, the S/N can be improved by 30 times only in a simple magnetic sensitivity comparison.

However, the reduction in size and thickness cannot be achieved in the hybrid configuration. Cellular phones in recent years have increasingly been reduced in thickness, and the thickness of the product package for use in the cellular phones is 0.6 mm or less in many cases. First of all, the hybrid configuration has a disadvantage to the package size demanded as a portable product in that a wire is used for connection of a sensor and a signal processing circuit, so that the package size is large and thick.

On the other hand, in the sensor device according to Example 1, the compound semiconductor sensor element is formed between the metal wiring layers, and therefore the size can be reduced and a compound hall element which achieves high magnetic sensitivity can be used.

As compared with the configuration in which a compound semiconductor sensor element is connected to a signal processing circuit using wire bonding, metal lead wiring, or the like, the configuration in which the elements are disposed between the metal wiring layers is strong against a disturbance noise. Since the elements are disposed between the metal wiring layers, the parasitic capacitance and the parasitic inductance due to the wiring of the compound semiconductor sensor element become as small as 1/10,000 or less of those of a former configuration and the sensor device becomes strong against a disturbance electromagnetic noise due to a noise source (for example, radiation source of electromagnetic waves of a commercial power source, a motor, a switching element, an electric light, and the like) which are present in large space outside the LSI. Furthermore, a configuration most suitable for a high-speed chopping operation is achieved due to the reduction in the parasitic capacitance and the parasitic inductance of the compound semiconductor sensor element.

According to a method for manufacturing the sensor device of Example 1 described later, a semiconductor device containing a signal processing circuit of a sensor and a compound semiconductor thin film can be formed in one wafer as a process. An interlayer insulating film of $SiO_2$, TEOS, SiN, or the like on the semiconductor device is amorphous, and therefore a good-quality crystalline semiconductor thin film with high sensor sensitivity cannot be grown thereon. However, according to a method for manufacturing the sensor device of Example 1, the compound semiconductor sensor element can be formed on the interlayer insulating film.

Furthermore, in PTL 1 described above, when an attempt of correcting the sensor characteristics is made, only individualized and separated sensors in which the number of a mass-production wafer or the position in a mass-production wafer cannot be specified are selectable, and therefore the sensor characteristics of four sensors to be used are not uniform, so that low-cost and efficient sensor characteristic correction cannot be performed. However, according to the method for manufacturing the sensor device of Example 1, variations in sensor characteristics and reference resistance can be reduced, so that efficient sensor characteristic correction can be performed. The sensor device may be configured as a sensor IC chip.

<Manufacturing method 1>

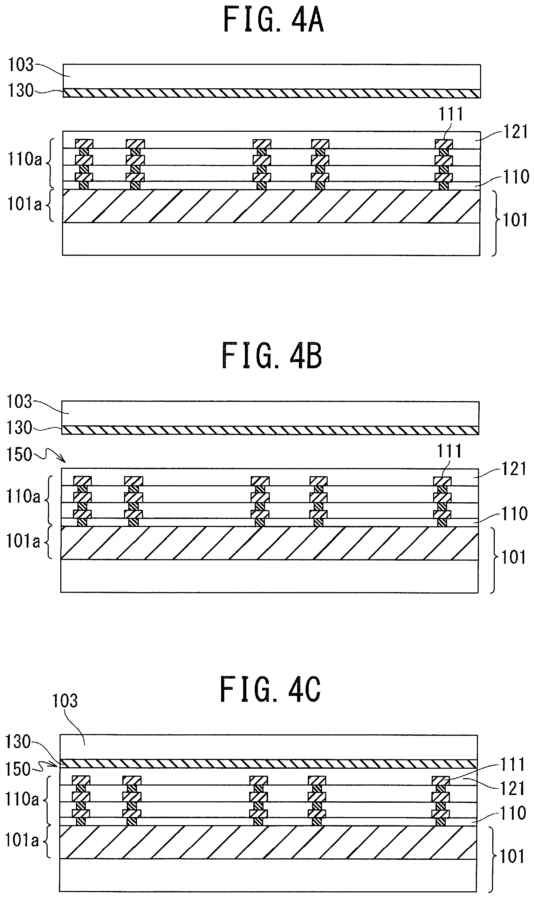

Figs. 4A to 4C to Figs. 6G to 6I are process flow diagrams for explaining a manufacturing method 1 for the sensor device according to Example 1 described above.

A manufacturing method 1 for the sensor device 100 has a step of forming the first metal wiring layer 111 on the semiconductor substrate 101, a step of forming the first insulating layer 121 on the first metal wiring layer 111, a step of forming the compound semiconductor sensor element 131 on the first insulating layer 121, a step of stacking the third insulating layer 123 after forming the compound semiconductor sensor element 131, and a step of forming the second metal wiring layer 112 on the third insulating layer 123.

The step of forming the compound semiconductor sensor element 131 has a step of forming the compound semiconductor film 130 on the first insulating layer 121 and a step of etching the compound semiconductor film 130 into a predetermined shape to form the compound semiconductor sensor element 131.

The step of forming the compound semiconductor sensor element 131 has a step of forming the compound semiconductor film 130 on the first insulating layer 121 and a step of forming the compound semiconductor film 130 into the compound semiconductor sensor element 131 by lithography and etching.

The step of forming the compound semiconductor sensor element 131 has a step of sticking the compound semiconductor film 130 to the first insulating layer 121 and a step of forming the compound semiconductor film 130 into the compound semiconductor sensor element 131 by lithography and etching.

The step of sticking the compound semiconductor film 130 to the first insulating layer 121 includes sticking the compound semiconductor film 130 formed on the substrate 103 to the first insulating layer 121, and then selectively removing the substrate 103.

The step of forming the first insulating layer 121 has a step of stacking the first insulating layer 121 onto the first metal wiring layer 111 and a step of planarizing the upper surface of the first insulating layer 121.

Simultaneously with the step of forming the compound semiconductor sensor element 131 on the first insulating layer 121, the correction resistance element 132 is formed. The compound semiconductor sensor element 131 and the correction resistance element 132 are formed from the same compound semiconductor film 130.

More specifically, as illustrated in Fig. 4A, the first metal wiring layer 111 is first formed on the semiconductor substrate 101 in which the semiconductor device region 101a is formed on a silicon wafer, and then the first insulating layer 121 is formed on the first metal wiring layer 111. The formation is performed by a method performed in a general CMOS process.

A substrate (for example, silicon wafer) 103 is prepared, and then the semiconductor thin film 130 to be used for sticking is formed on the silicon wafer as an example. The semiconductor thin film 130 is formed on the silicon substrate by MBE (Molecular Beam Epitaxy), CVD (Chemical Vapor Deposition), MOCVD (Metal Organic Chemical Vapor Deposition), or the like.

Next, as illustrated in Fig. 4B, the planarized surface 150 is formed on the surface of the first insulating layer 121. For the planarized surface 150, the first insulating layer 121 to be used in a so-called semiconductor manufacturing technique, such as $SiO_2$, TEOS, SiN, or the like, is uniformly formed, and then planarizing treatment, such as CMP (Chemical Mechanical Polishing), is performed as necessary.

Next, as illustrated in Fig. 4C, the semiconductor thin film 130 on the substrate 103 and the planarized surface 150 of the first insulating layer 121 are stuck to each other. A room temperature covalent bond is mentioned as an example of the sticking method. The principle of the room temperature covalent bond is described. The surfaces of materials to be jointed are irradiated with ion beams or neutral atom beams in a high vacuum, whereby an oxide film and an adsorption layer on the surface of the material are removed, so that "bond" which is originally imparted to the materials appears, which is referred to as "activated surface". Then, when the activated surfaces are brought into contact with each other, the bonding power instantly works, so that the two materials are firmly joined to each other. It is known that, when the grating constants of the materials to be stuck are different from each other, a very thin amorphous layer of several nanometers in which the components of the materials are mixed is formed, and then the two materials are bonded to each other with the layer as a buffer layer.

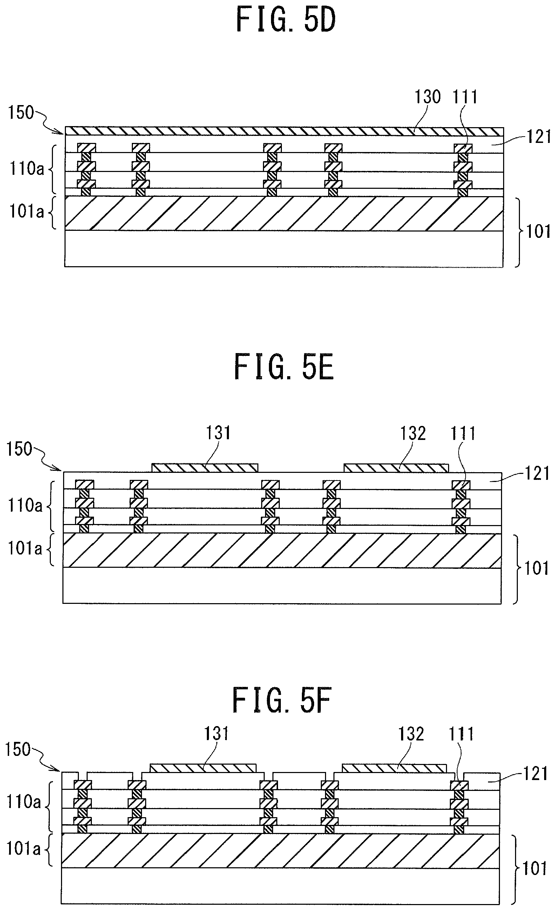

Next, as illustrated in Fig. 5D, after the sticking, only the silicon substrate on the side of the semiconductor thin film 130 is selectively etched with a CF4-based etching gas. Thus, the semiconductor thin film 130 is left on the planarized surface 150 on the side of the semiconductor substrate 101. If necessary, predetermined impurities may be implanted in the state where the semiconductor thin film 130 is present on the planarized surface 150 on the side of the semiconductor substrate 101.

Next, as illustrated in Fig. 5E, the semiconductor thin film 130 stuck to the planarized surface 150 is simultaneously formed into the shapes of the compound semiconductor sensor element (for example, hall element) 131 and the correction resistance element 132 by lithography and etching. Thus, the compound semiconductor sensor element 131 is formed on the first insulating layer 121.

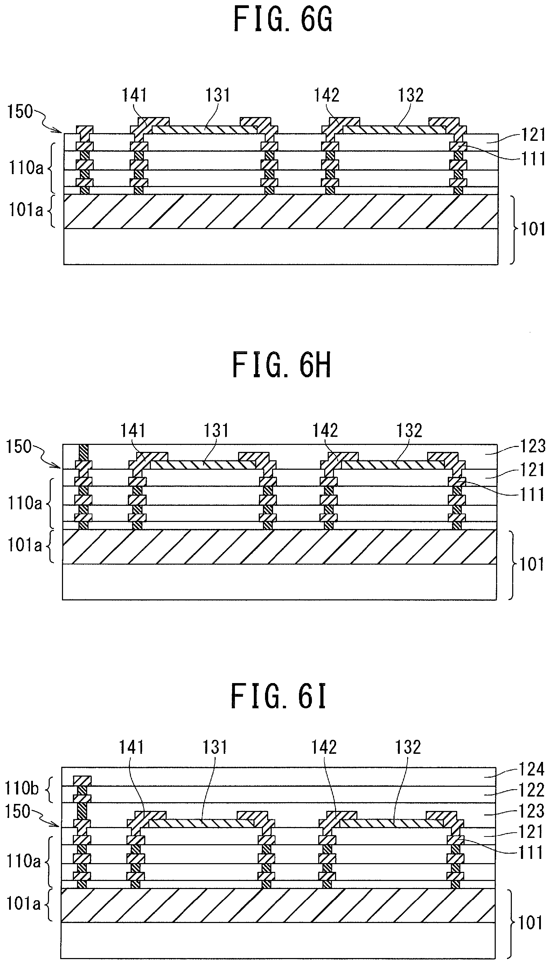

Next, as are illustrated in Fig. 5F, VIAs (hole) 102 are formed in the planarized surface 150 of the first insulating layer 121 using a lithography and etching process. Further, as illustrated in Fig. 6G, wiring connecting the compound semiconductor sensor element 131 and the sensor characteristic correction resistance element 132 to the semiconductor integrated circuit in the semiconductor substrate 101 through the VIAs 102 formed in the first insulating layer 121 is formed by lithography and etching. Thus, the compound semiconductor sensor element 131 and the sensor characteristic correction resistance element 132 are connected to the semiconductor integrated circuit.

Next, as illustrated in Fig. 6H, an interlayer insulating film which is the third insulating layer 123 is formed on the compound semiconductor sensor element 131, the wiring 141 for sensor element, and the first insulating layer 121.

Next, as illustrated in Fig. 6I, an upper wiring process of a semiconductor process is performed. Thus, the second metal wiring layer 112 is formed. Furthermore, in the following process, a step of forming a PAD for external connection may be provided.

As is understood from the description above, by forming the compound semiconductor sensor element 131 and the sensor characteristic correction resistance element 132 integrally with a so-called back-end process of a semiconductor process, a sensor device having high S/N and excellent temperature characteristics can be stored in one small and thin package and realized.

Moreover, the compound semiconductor sensor element 131 and the sensor characteristic correction resistance element 132 are simultaneously formed, and therefore it is expectable that the variation in the characteristics between individual products is also very small. According to the manufacturing method 1 for the sensor device 100 of Example 1, variations in the sensor characteristics and the reference resistance can be reduced and efficient sensor characteristic correction can be performed.

Moreover, wire bonding required in hybrid configuration becomes unnecessary, so that the saving of wiring materials, such as expensive Au, and the cost reduction can be achieved.

<Manufacturing method 2>

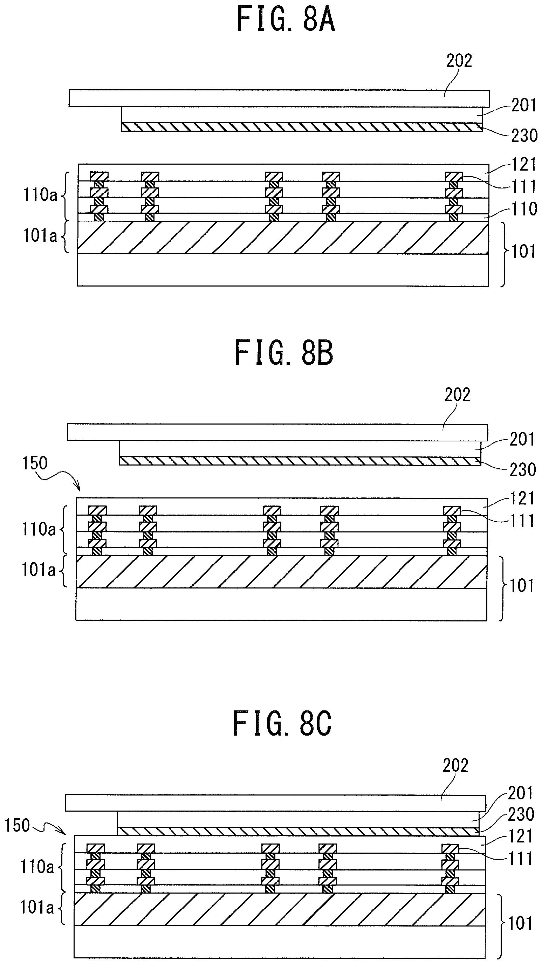

Figs. 8A to 8C to Figs. 10G to 10I are process flow diagrams for explaining a manufacturing method 2 for the sensor device according to Example 1.

The manufacturing method 2 for the sensor device 100 has a step of forming the first metal wiring layer 111 on the semiconductor substrate 101, a step of forming the first insulating layer 121 on the first metal wiring layer 111, a step of forming a compound semiconductor sensor element 231 on the first insulating layer 121, a step of stacking the third insulating layer 123 after forming the compound semiconductor sensor element 231, and a step of forming the second metal wiring layer 112 on the third insulating layer 123.

The step of forming the compound semiconductor sensor element 231 has a step of forming a compound semiconductor film 230 on the first insulating layer 121 and a step of etching the compound semiconductor film 230 into a predetermined shape to form the compound semiconductor sensor element 231.

The step of forming the compound semiconductor sensor element 231 has a step of forming the compound semiconductor film 230 on the first insulating layer 121 and a step of forming the compound semiconductor film 230 into the compound semiconductor sensor element 231 by lithography and etching.

The step of forming the compound semiconductor sensor element 231 has a step of sticking the compound semiconductor film 230 to the first insulating layer 121 and a step of forming the compound semiconductor film 230 into the compound semiconductor sensor element 231 by lithography and etching.

The step of sticking the compound semiconductor film 230 to the first insulating layer 121 includes sticking the compound semiconductor film 230 formed on the substrate 103 to the first insulating layer 121, and then selectively removing the substrate 103.

The step of forming the first insulating layer 121 has a step of stacking the first insulating layer 121 onto the first metal wiring layer 111 and a step of planarizing the upper surface of the first insulating layer 121.

Simultaneously with the step of forming the compound semiconductor sensor element 231 on the first insulating layer 121, the correction resistance element 232 is formed. The compound semiconductor sensor element 231 and the correction resistance element 232 are formed from the same compound semiconductor film 230.

More specifically, as illustrated in Fig. 8A, the first metal wiring layer 111 is first formed on a semiconductor substrate 102 in which the semiconductor device region 101a is formed on a silicon wafer, and then the first insulating layer 121 is formed on the first metal wiring layer 111. The formation is performed by a method performed in a general CMOS process.

A substrate (for example, silicon wafer) 202 is prepared, and then the semiconductor thin film 230 to be used for sticking is formed on the silicon wafer as an example.

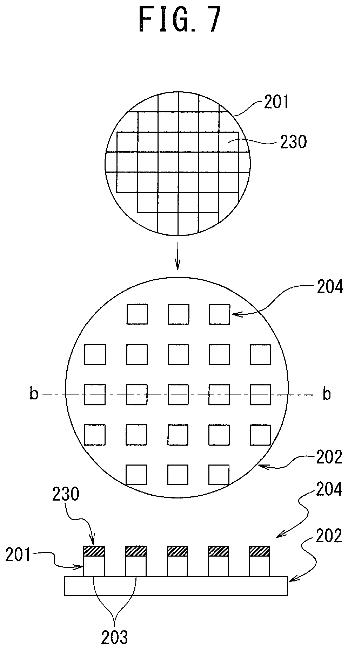

Fig. 7 is a flow diagram for explaining the formation of the semiconductor thin film on the substrate in the manufacturing method 2 of Example 1.

The semiconductor thin film 230 is formed on a first silicon wafer 201, and then individualized chips of the first silicon wafer 201 on which the semiconductor thin film 230 is formed are formed with adhesives 203 on a second silicon wafer 202 which is a temporary support substrate.

More specifically, first, the semiconductor thin film 230 is formed on the first silicon wafer 201 by MBE (Molecular Beam Epitaxy), CVD (Chemical Vapor Deposition), or MOCVD (Metal Organic Chemical).

Next, the first silicon wafer 201 on which the semiconductor thin film 230 is formed is individualized into an appropriate size. Then, the first silicon wafers 201 are bonded to the second silicon wafer 202 which is a temporary support substrate with the adhesives 203 for tentative fixing to be disposed.

Next, as illustrated in Fig. 8B, the planarized surface 150 is formed on the surface of the first insulating layer 121.

For the planarized surface 150, the first insulating layer 121 to be used in a so-called semiconductor manufacturing technique, such as $SiO_2$, TEOS, SiN, or the like, is uniformly formed, and then planarizing treatment, such as CMP (Chemical Mechanical Polishing), is performed as necessary.

Next, as illustrated in Fig. 8C, the semiconductor thin film on the second silicon wafer and the planarized surface of the first insulating layer are stuck to each other.

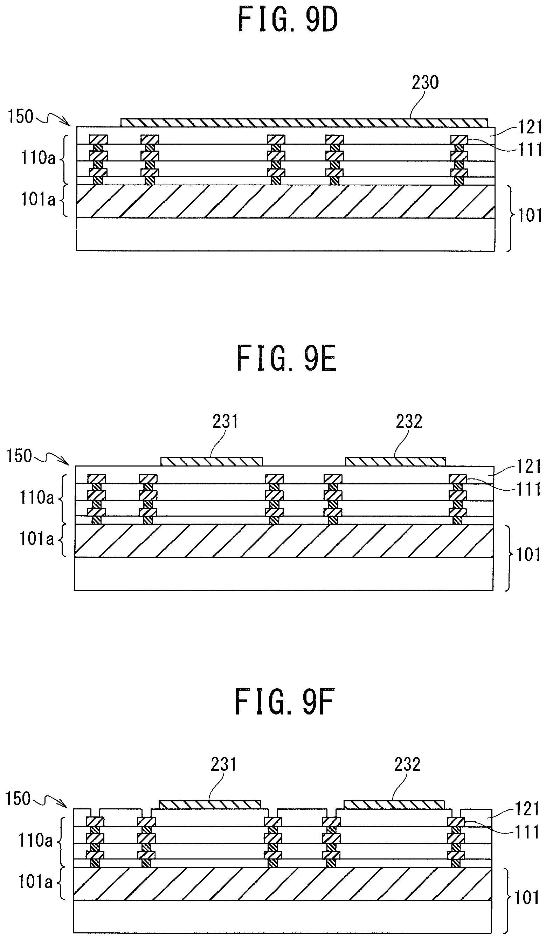

Next, as illustrated in Fig. 9D, when heat is applied to the temporary support substrate 202 from the back surface of the wafer as an example, the adhesives 203 are softened, so that the temporary support substrate 202 can be easily separated. As an example, depending on the type of adhesives, some adhesives are softened when irradiated with ultraviolet rays, so that the temporary support substrate 202 can be easily separated.

After sticking the individualized chip 204, only the silicon on the side of the semiconductor thin film is selectively etched with a CF4-based etching gas to leave the semiconductor thin film 230 on the planarized surface 150 on the side of the semiconductor substrate 101. If necessary, predetermined impurities may be implanted in the state where the semiconductor thin film 230 is present on the planarized surface 150 on the side of the semiconductor substrate 101.

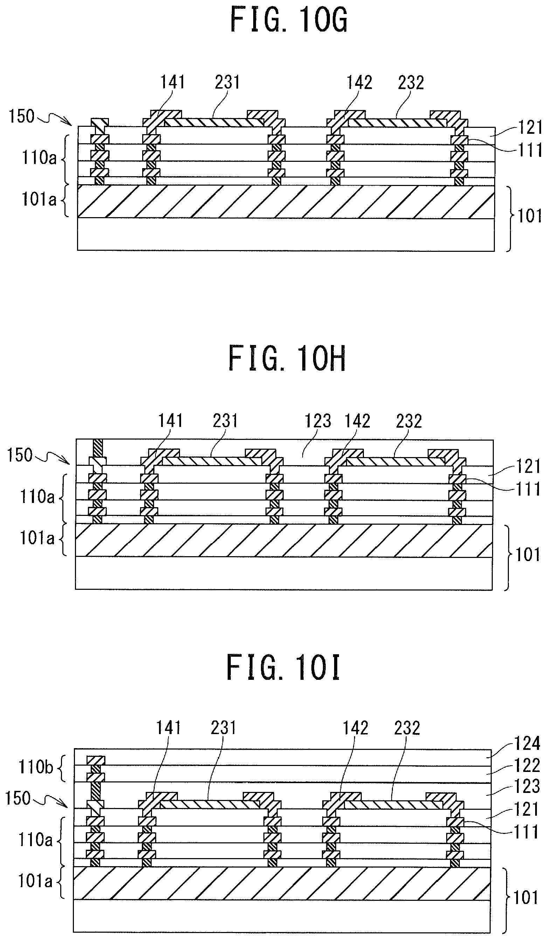

Next, the processes of Figs. 9E to 9F and Figs. 10G to 10I are the same as the processes of Figs. 5E to 5F and Figs. 6G to 6I illustrating the processes of the manufacturing method 1 described above.

As the effect of the manufacturing method 2, by sticking the compound semiconductor thin film only to a region where the compound semiconductor thin film is required on the semiconductor integrated circuit side by employing the technique of sticking the individualized chips, an expensive compound semiconductor wafer can be used with no waste. Moreover, the types of the individualized compound semiconductor thin films can be made into a plurality of types different in the characteristics and products having different characteristics can also be collectively manufactured.

<Example 2>

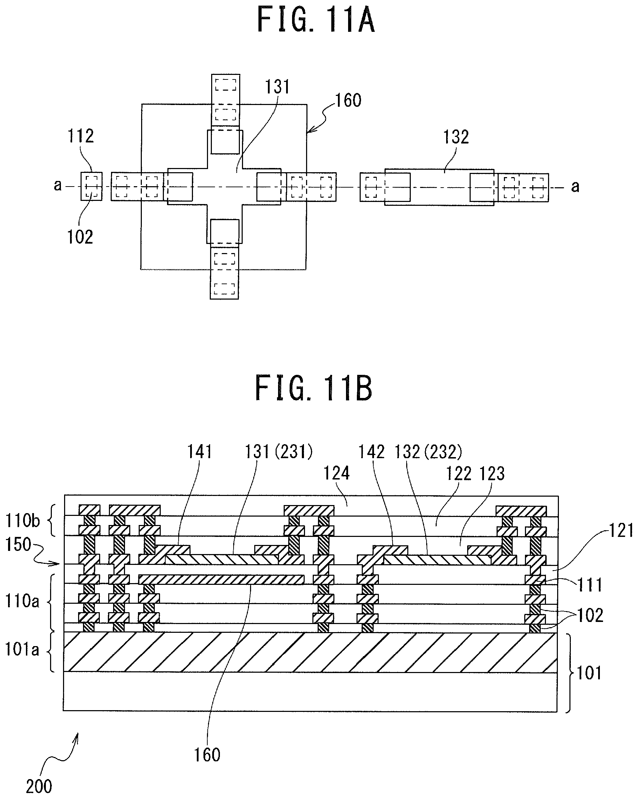

Figs. 11A and 11B are block diagrams for explaining Example 2 of the sensor device according to the present invention. Fig. 11A illustrates a top view and Fig. 11B illustrates a cross sectional view along the a-a line of Fig. 11A. The constituent elements having the same function as those of Example 1 illustrated in Figs. 3A and 3B are designated by the same reference numerals.

The configuration different from that of Example 1 described above is a configuration in which a shield layer 160 is formed on the lower wiring layer 110a located under the sensor for shielding a noise due to an electrostatic bond from the semiconductor integrated circuit.

A sensor device 200 of Example 2 has a semiconductor substrate 101, a first metal wiring layer 111 formed on the semiconductor substrate 101, a first insulating layer 121 provided on the first metal wiring layer 111, a compound semiconductor sensor element 131 (231) provided on the first insulating layer 121, a second metal wiring layer 112 provided on the compound semiconductor sensor element 131 (231) and the first insulating layer 121, and a second insulating layer 122 provided on the second metal wiring layer 112.

Moreover, a third insulating layer 123 is provided between the first metal wiring layer 111 and the second metal wiring layer 112 and the compound semiconductor sensor element 131 (231) is formed in the third insulating layer 123.

The compound semiconductor sensor element 131 (231) is electrically connected to the first metal wiring layer 111 or the second metal wiring layer 112.

The compound semiconductor sensor element 131 (231) preferably has a thin film shape. The first metal wiring layer 111 has the shield layer 160 disposed below the compound semiconductor sensor element 131 (231).

Moreover, a correction resistance element 132 (232) provided on the same plane as a plane on which the compound semiconductor sensor element 131 (231) is provided is further provided. The compound semiconductor sensor element 131 (231) is a hall element or a magnetoresistive element.

The compound semiconductor sensor element 131 (231) is formed on the planarized surface 150 of the first insulating layer 121. An external connection contact (not illustrated) may be provided on the second insulating layer 122.

More specifically, the sensor device 200 of Example 2 has the semiconductor substrate 101, the lower wiring layer 110a, the compound semiconductor sensor element 131 (231), the wiring 141 for sensor element, the third insulating layer 123, the upper metal wiring layer 110b, and the shield layer 160.

As described above, a different configuration between Example 2 and Example 1 is the configuration in which the shield layer 160 is formed on the lower wiring layer 110a located under the sensor for shielding a noise due to an electrostatic bond from the semiconductor integrated circuit. Due to the fact that the shield layer 160 is formed below the compound semiconductor sensor element 131 (231), the compound semiconductor sensor element can be disposed also directly above a digital circuit having a very large number of frequency components and the degree of freedom of layout dramatically increases.

The wiring 141 for sensor element is formed so that the terminal of the compound semiconductor sensor element 131 (231) is connected to the second metal wiring layer 112 of the upper wiring layer 110b. One end of the correction resistance element 132 (232) is connected to the upper wiring layer 110b and the other end thereof is connected to the lower wiring layer 110a.

Thus, the terminal of the compound semiconductor sensor element and the correction resistance element may be connected to either or both of the upper wiring layer or the lower wiring layer.

<Embodiment of the invention>

The Embodiment of the present invention is an embodiment in which a plurality of magnetic sensors, such as a hall element and a magnetoresistive element, are formed as a compound semiconductor sensor element.

The Embodiment has a semiconductor substrate 101, a first compound semiconductor magnetic sensor provided in an insulating layer between a first metal wiring layer 111 and a second metal wiring layer 112 provided on the semiconductor substrate 101, and a second compound semiconductor magnetic sensor provided in an insulating layer between the second metal wiring layer 112 and a third metal wiring layer on the second metal wiring 112. Thus, the configuration in which the compound semiconductor magnetic sensors are disposed between the metal wiring layers may be acceptable. In addition, the second metal wiring layer may contain a plurality of metal wiring layers.

The second compound semiconductor magnetic sensor is formed above the first compound semiconductor magnetic sensor as viewed in a cross section. Thus, when an external magnetic field perpendicular to the semiconductor substrate is detected, magnetic fields input into the first compound semiconductor magnetic sensor and the second compound semiconductor magnetic sensor are the almost same value. Thus, the functional security required in ISO26262 can be achieved by one chip in the magnetic sensor. In particular, the compound semiconductor magnetic sensors are disposed in the vertical direction as viewed in a cross section in one chip instead of different IC chips, and therefore there is also no error in assembly and an accurate functional security can be achieved.

It is more desirable that the first compound semiconductor magnetic sensor and the second compound semiconductor magnetic sensor are magnetic sensors containing the same compound semiconductor.

As a sensor IC chip, an external connection terminal or a PAD may be provided.

<Application Example 1>

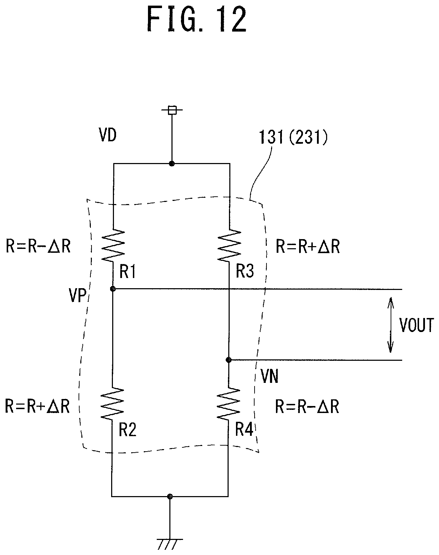

Fig. 12 is a circuit diagram illustrating an example of a compound semiconductor sensor element and a semiconductor integrated circuit in an application example of the sensor devices of Examples 1 and 2.

The circuit diagram is a circuit diagram of a four-terminal sensor (compound semiconductor sensor element) for which a four-terminal circuit configuration or an equivalent circuit can be considered, and a hall element, an anti-magnetic element, a distortion sensor, a pressure sensor, a temperature sensor, an acceleration sensor, and the like are typically represented by the circuit diagram.

In Fig. 12, to changes in a physical quantity B, a sensor resistance R1 and a sensor resistance R4 have sensitivity in a direction where the resistance of itself decreases as small as $-\Delta R$, and a sensor resistance R2 and a sensor resistance R3 have sensitivity in a direction where the resistance of itself increases as large as $+\Delta R$, and a four-terminal resistance bridge is formed.

In Fig. 12, the output of the four-terminal sensor is calculated by defining the drive current of the four-terminal sensor as IB.

First, when the combined resistance of the four-terminal sensor is defined as RA, RA is given as follows:

$$RA=1/(1/(R1+R2)+1/(R3+R4))$$
$$= (R1+R2)\times(R3+R4)/(R1+R2+R3+R4).$$

For ease of understanding, R1=R4=R-$\Delta$R and R2=R3=R+$\Delta$R are set, and the resistance values at the reference temperature TNOM, e.g., TNOM= Room temperature 25°C, are defined as R and $\Delta$R. Then, the combined resistance RA at the reference temperature is given as RA=R.

Therefore, the drive voltage applied to the four-terminal sensor is given as VD=IB$\times$R.

The sensor output VOUT is given as a differential voltage of a plus terminal and a minus terminal. When the output voltage of the plus terminal is defined as VP and the output of the minus terminal is defined as VN,

$$VOUT=VP-VN$$

$$=IB \times R \times R2/(R1+R2) - IB \times R \times R4/(R3+R4)$$

is given.

Also herein, when R1=R4=R-ΔR and R2=R3=R+ΔR are set,

$=IB \times R \times ((R+\Delta R)/(2 \times R) - (R - \Delta R)/(2 \times R))$

$=IB \times \Delta R$ is given.

Herein, when the temperature characteristic of the sensor resistance is expressed as the resistance values R and ΔR at the reference temperature TNOM and further a function f(T-TNOM) of the temperature characteristic of the resistance,

$$RT=R \times f(T-TNOM)$$

$$\Delta RT=\Delta R \times f(T-TNOM)$$

are given.

Therefore, when the four-terminal sensor is driven at the constant current IB, the temperature characteristic of the sensor output VOUT is the temperature characteristic f(T-TNOM) of the sensor resistance itself from the expression.

<Application Example 2>

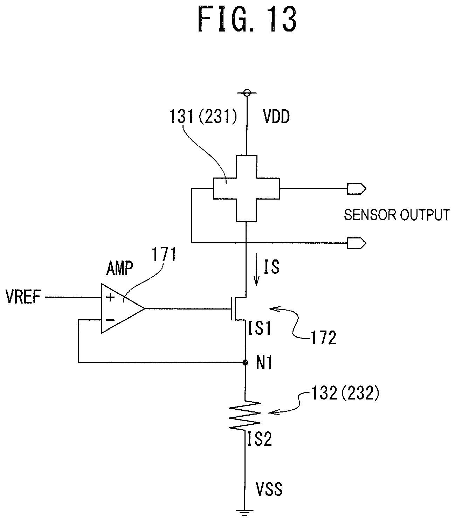

Fig. 13 is a circuit diagram illustrating an example in which the temperature characteristics of the sensor devices can be made constant in an application example of the sensor devices of Examples 1 and 2. In the figure, the reference numeral 171 denotes an AMP and the reference numeral 172

denotes an NMOS transistor.

The circuit contains a compound semiconductor sensor element and a constant current circuit driving the compound semiconductor sensor element. The constant current circuit is a circuit in which an operational amplifier, an NMOS transistor, and a sensor characteristic correction resistance element are combined and which generates a constant current of a magnitude depending on a VREF voltage to be externally input and a resistance value of the sensor characteristic correction resistance element as an example.

In particular, the sensor characteristic correction resistance element is formed by lithography and etching from the same thin film from which the compound semiconductor sensor element is formed, and therefore the temperature characteristic of the correction resistance element is expressed by the same temperature characteristic f(T-TNOM) as the temperature characteristic of the compound semiconductor sensor element. When the resistance value at the reference temperature TNOM, e.g., TNOM= Room temperature 25°C, of the sensor characteristic correction resistance element, is defined as RREF, it is used for a current source of the sensor driving circuit as in an example of Fig. 13, whereby the sensor drive current IB is given as

$$IB=VREF/(RREF \times f(T-TNOM)).$$

On the other hand, the sensor output is given as, referring to the expression,

$$VOUT=IB \times \Delta R \times f(T-TNOM)$$

$$=VREF/(RREF \times f(T-TNOM)) \times \Delta R \times f(T-TNOM)$$

$$=VREF \times (\Delta R/RREF),$$

which shows that the temperature characteristic is canceled.

<Application Example 3>

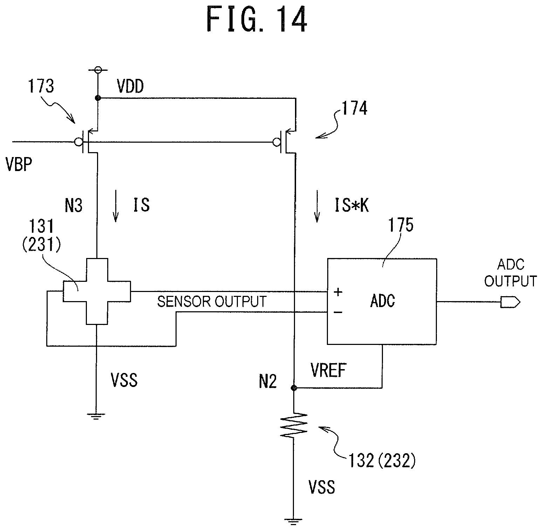

Fig. 14 is a circuit diagram illustrating another example in which the temperature characteristics of the sensor devices in an application example of the sensor devices of Examples 1 and 2 can be made constant. In the figure, the reference numerals 173 and 174 denote PMOS transistors and the reference numeral 175 denotes an ADC.

The circuit contains the compound semiconductor sensor element 131 (231), a sensor driving circuit driving the compound semiconductor sensor element 131 (231) at a constant current, an ADC 175, and a voltage generating circuit generating a reference voltage of the ADC 175.

The compound semiconductor sensor element is driven at a constant current IS. When a description is given including the temperature characteristic of the sensor, the sensor output is given as, referring to Expression,

$$VOUT=IB \times \Delta R \times f(T-TNOM).$$

On the other hand, the magnitude corresponding to digitized 1 bit of the ADC is determined by scaling the magnitude of the reference voltage VREF. In the example of Fig. 14, the reference voltage VREF of the ADC is a voltage generated by the product of a current of a constant current K×IS of a magnitude obtained by multiplying the constant current IS by a fixed magnification K and a resistance value of the sensor characteristic correction resistance element. Since the sensor characteristic correction resistance element is formed by lithography and etching from the same thin film from which the compound semiconductor sensor element is formed, the temperature characteristic of the correction resistance element is expressed by the same temperature characteristic f(T-TNOM) as the temperature characteristic of the compound semiconductor sensor element. When the resistance value at the reference temperature TNOM, e.g., TNOM=Room temperature 25°C, of the sensor characteristic correction resistance element is defined as RREF, the reference voltage VREF of the ADC is given as

$$VREF=K \times IS \times RREF \times f(T-TNOM).$$

Therefore, the temperature dependency of a digital code obtained by AD-converting the VOUT and the temperature dependency of the VREF voltage are the same, and therefore the output code of the sensor independent on the temperature characteristic is obtained.

The above description is given for the sensor device but the present invention is applicable also as a semiconductor device having the semiconductor substrate 101 and the compound semiconductor element 131 (231) provided in the insulating layer 123 between the first metal wiring layer 111 and the second metal wiring layer 112 provided on the semiconductor substrate 101.

Reference Signs List

| 1 | detecting unit |
|---|---|
| 2 | differential amplifier |
| 3 | A/D converter |
| 4 | detection controlling unit |
| 5 | coordinate converting unit |
| 6 | coordinates switching unit |
| 7 | output method storage unit |
| 8 | output controlling unit |
| 11 | hall element |
| 51 | distance calculating unit |
| 52 | angle calculating unit |
| 53 | distance output limiting unit |
| 21 | hall element |
| 22 | integrated circuit |
| 23 | lead frame |
| 24 | mold resin |
| 25 | wire |

| 100,200 | sensor device |
| 101 | semiconductor substrate |
| 102 | VIA |
| 103 | substrate |
| 110 | interlayer insulating layer |
| 110a | lower wiring layer |
| 110b | upper wiring layer |
| 111 | first metal wiring layer |
| 112 | second metal wiring layer |
| 121 | first insulating layer |
| 122 | second insulating layer |
| 123 | third insulating layer |
| 130,230 | compound semiconductor film |
| 131,231 | compound semiconductor sensor element |
| 132,232 | correction resistance element |
| 141 | wiring for sensor element |
| 142 | wiring for correction resistance element |
| 150 | planarized surface |
| 160 | shield layer |
| 171 | AMP |
| 172 | NMOS transistor |
| 173,174 | PMOS transistor |
| 175 | ADC |
| 201 | first silicon wafer |
| 202 | second silicon wafer |
| 203 | adhesive |
| 204 | individualized chip |

## Claims

**1.** A sensor device (100) comprising:

a semiconductor substrate (101);
a first compound semiconductor magnetic sensor provided in an insulating layer (121) between a first metal wiring layer (111) and a second metal wiring layer (112) provided on the semiconductor substrate; and
a second compound semiconductor magnetic sensor provided in an insulating layer between the second metal wiring (112) and a third metal wiring layer on the second metal wiring layer (112),
**characterized in that**
the second compound semiconductor magnetic sensor is formed above the first compound semiconductor magnetic sensor as viewed in a cross section.

## Patentansprüche

**1.** Sensorvorrichtung (100), umfassend:

ein Halbleitersubstrat (101);
einen ersten Verbindungshalbleitermagnetsensor, der in einer Isolierschicht (121) zwischen einer ersten Metallverdrahtungsschicht (111) und einer zweiten Metallverdrahtungsschicht (112), die auf dem Halbleitersubstrat bereitgestellt sind, bereitgestellt ist; und
einen zweiten Verbindungshalbleitermagnetsensor, der in einer Isolierschicht zwischen der zweiten Metallverdrahtung (112) und einer dritten Metallverdrahtungsschicht auf der zweiten Metallverdrahtungsschicht (112) bereitgestellt ist, **dadurch gekennzeichnet, dass**
der zweite Verbindungshalbleitermagnetsensor über dem ersten Verbindungshalbleitermagnetsensor gebildet ist, in einem Querschnitt betrachtet.

**Revendications**

1. Dispositif de capteur (100) comprenant :

   un substrat semi-conducteur (101) ;
   un premier capteur magnétique semi-conducteur composé fourni dans une couche isolante (121) entre une première couche de câblage métallique (111) et une deuxième couche de câblage métallique (112) fournie sur le substrat semi-conducteur ; et
   un deuxième capteur magnétique semi-conducteur composé fourni dans une couche isolante entre la deuxième couche de câblage métallique (112) et une troisième couche de câblage métallique sur la deuxième couche de câblage métallique (112),
   **caractérisé en ce que**
   le deuxième capteur magnétique semi-conducteur composé est formé au-dessus du premier capteur magnétique semi-conducteur composé tel que vu dans une section transversale.

# FIG. 1

# FIG. 2

# FIG. 3A

# FIG. 3B

# FIG. 4A

# FIG. 4B

# FIG. 4C

# FIG. 5D

# FIG. 5E

# FIG. 5F

# FIG. 6G

# FIG. 6H

# FIG. 6I

# FIG. 7

# FIG. 8A

# FIG. 8B

# FIG. 8C

# FIG. 9D

# FIG. 9E

# FIG. 9F

# FIG. 10G

# FIG. 10H

# FIG. 10I

# FIG. 11A

# FIG. 11B

# FIG. 12

# FIG. 13

131 (231)    VDD

SENSOR OUTPUT

IS

AMP    171

VREF

IS1    172

N1

132 (232)

IS2

VSS

# FIG. 14

**EP 3 217 445 B1**

## REFERENCES CITED IN THE DESCRIPTION

### Patent documents cited in the description

- JP 10020999 A
- JP 2004069695 A
- JP 2004207323 A
- KR 1020100124493 A

- US 20060202291 A1
- JP 2002299599 A
- JP 2006047080 A
- WO 0028342 A1